# EUROPÄISCHE PATENTANMELDUNG

(11) **EP 4 682 953 A1**
(43) Veröffentlichungstag der Anmeldung: **21.01.2026**
(21) Anmeldenummer: 24189746.1
(22) Anmeldetag: 19.07.2024
(51) Int. Cl.: H01L 23/31, H01L 23/373, H01L 23/40, H01L 23/473, H01L 25/07, H01L 23/00, H01L 23/12

(54) **HALBLEITERANORDNUNG MIT ZUMINDEST EINEM HALBLEITERELEMENT, EINEM ERSTEN SCHALTUNGSTRÄGER UND EINEM ZWEITEN SCHALTUNGSTRÄGER**

(71) Anmelder: Siemens Aktiengesellschaft, 80333 München (DE)
(72) Erfinder: Sewiolo, Benjamin, 90587 Obermichelbach (DE)
(74) Vertreter: Siemens Patent Attorneys

(57) **Zusammenfassung**

Die Erfindung betrifft ein Verfahren zur Herstellung einer Halbleiteranordnung (2), insbesondere einer Leistungshalbleiteranordnung für einen Stromrichter (56), mit zumindest einem Halbleiterelement (4), einem ersten Schaltungsträger (6) und einem zweiten Schaltungsträger (8). Um die Rezyklierbarkeit oder Reparierbarkeit einer Halbleiteranordnung, welche mittels planarer Aufbau- und Verbindungstechnik realisiert ist, zu verbessern, wird vorgeschlagen, dass das Halbleiterelement (4) einen ersten Lastkontakt (10) und auf einer dem ersten Lastkontakt (10) gegenüberliegenden Seite einen zweiten Lastkontakt (12) aufweist, wobei zwischen dem ersten Schaltungsträger (6) und dem ersten Lastkontakt (10) des Halbleiterelements (4) und/oder zwischen dem zweiten Schaltungsträger (8) und dem zweiten Lastkontakt (12) des Halbleiterelements (4) eine elastische Pufferlage (28) angeordnet wird, wobei das Halbleiterelement (4) durch Befestigungsmittel (32) zwischen den Schaltungsträgern (6, 8) kraftschlüssig verbunden wird, wobei über die Befestigungsmittel (32) eine senkrecht auf das Halbleiterelement (4) wirkende Kraft (F) übertragen wird, wobei die elastische Pufferlage (28) in Richtung der Kraft (F) komprimiert wird.

## Beschreibung

Die Erfindung betrifft ein Verfahren zur Herstellung einer Halbleiteranordnung, insbesondere einer Leistungshalbleiteranordnung für einen Stromrichter, mit zumindest einem Halbleiterelement, einem ersten Schaltungsträger und einem zweiten Schaltungsträger.

Ferner betrifft die Erfindung eine Halbleiteranordnung, insbesondere Leistungshalbleiteranordnung für einen Stromrichter, mit zumindest einem Halbleiterelement, einem ersten Schaltungsträger und einem zweiten Schaltungsträger.

Überdies betrifft die Erfindung einen Stromrichter mit mindestens einer derartigen Halbleiteranordnung.

Darüber hinaus betrifft die Erfindung ein Verfahren zum Rezyklieren oder Reparieren einer derartigen Halbleiteranordnung.

Derartige Halbleiteranordnungen kommen beispielsweise in einem Stromrichter zum Einsatz. Unter einem Stromrichter ist beispielsweise ein Gleichrichter, ein Wechselrichter, ein Umrichter oder ein Gleichspannungswandler zu verstehen. Üblicherweise umfassen derartige Halbleiteranordnungen ein Gehäuse, in welchem zumindest ein Halbleiterelement angeordnet ist. Ein derartiges Halbleiterelement kann unter anderem ein Transistor sein. Derartige Transistoren können unter anderem als Insulated-Gate-Bipolar-Transistoren (IGBTs) oder als Wide-Bandgap-Transistoren ausgeführt. Die Wide-Bandgap-Transistoren können beispielsweise in Siliziumcarbid- oder Galliumnitrid-Technologie realisiert sein und ermöglichen unter anderem höhere Schaltfrequenzen.

Eine planare Aufbau- und Verbindungstechnik von elektronischen Schaltungen führt nicht nur zu geringeren parasitären Induktivitäten der Leistungshalbleiter, was höhere Schaltfrequenzen ermöglicht, sondern auch zu erhöhten Leistungsdichten.

Die Offenlegungsschrift WO 2020/249479 A1 beschreibt einen elektronischen Schaltkreis mit einem ersten und einem zweiten Schaltungsträger sowie einem ersten und einem zweiten Halbleiterbauelement. Das erste Halbleiterbauelement liegt mit einer Oberseite an einer Unterseite des ersten Schaltungsträgers an sowie mit einer Unterseite an einer Oberseite des zweiten Schaltungsträgers. Der erste Schaltungsträger weist eine erste Durchkontaktierung auf, welche das erste Halbleiterbauelement mit einer ersten Leiterbahn verbindet. Der erste Schaltungsträger weist eine zweite Durchkontaktierung auf, welche ein zwischen den Schaltungsträgern angeordnetes Verbindungselement mit einer weiteren Leiterbahn elektrisch verbindet.

Die Offenlegungsschrift EP 4 300 574 A1 beschreibt ein bestückbares Leistungsmodul umfassend ein Leistungssubstrat mit einer Metallisierung, zumindest ein schaltbarer Die mit Leistungsanschlüssen, einen Interposer und zumindest ein erstes und ein zweites Kontaktelement, wobei die Kontaktelemente jeweils eine elektrische Kontaktierung einer der Leistungsanschlüsse des Dies am Interposer bereitstellen.

Umwelttechnische Aspekte gewinnen auch in der Elektronikentwicklung immer mehr an Bedeutung. Insbesondere rückt eine verbesserte Rezyklierbarkeit in den Fokus. Die Rezyklierbarkeit aber auch ein Reparaturaufwand werden beispielsweise durch den Wegfall von stoffschlüssigen Verbindungen, welche beispielsweise durch Löten, Sintern oder Schweißen herstellbar sind, verbessert.

Vor diesem Hintergrund ist es eine Aufgabe der vorliegenden Erfindung, die Rezyklierbarkeit oder Reparierbarkeit einer Halbleiteranordnung, welche mittels planarer Aufbau- und Verbindungstechnik realisiert ist, zu verbessern.

Diese Aufgabe wird erfindungsgemäß gelöst durch ein Verfahren zur Herstellung einer Halbleiteranordnung, insbesondere einer Leistungshalbleiteranordnung für einen Stromrichter, mit zumindest einem Halbleiterelement, einem ersten Schaltungsträger und einem zweiten Schaltungsträger, wobei das Halbleiterelement einen ersten Lastkontakt und auf einer dem ersten Lastkontakt gegenüberliegenden Seite einen zweiten Lastkontakt aufweist, wobei zwischen dem ersten Schaltungsträger und dem ersten Lastkontakt des Halbleiterelements und/oder zwischen dem zweiten Schaltungsträger und dem zweiten Lastkontakt des Halbleiterelements eine elastische Pufferlage angeordnet wird, wobei das Halbleiterelement durch Befestigungsmittel zwischen den Schaltungsträgern kraftschlüssig verbunden wird, wobei über die Befestigungsmittel eine senkrecht auf das Halbleiterelement wirkende Kraft übertragen wird, wobei die elastische Pufferlage in Richtung der Kraft komprimiert wird.

Ferner wird die Aufgabe erfindungsgemäß gelöst durch eine Halbleiteranordnung, insbesondere Leistungshalbleiteranordnung für einen Stromrichter, mit zumindest einem Halbleiterelement, einem ersten Schaltungsträger und einem zweiten Schaltungsträger, wobei das Halbleiterelement einen ersten Lastkontakt und auf einer dem ersten Lastkontakt gegenüberliegenden Seite einen zweiten Lastkontakt aufweist, wobei zwischen dem ersten Schaltungsträger und dem ersten Lastkontakt des Halbleiterelements und/oder zwischen dem zweiten Schaltungsträger und dem zweiten Lastkontakt des Halbleiterelements eine elastische Pufferlage angeordnet ist, wobei das Halbleiterelement durch Befestigungsmittel zwischen den Schaltungsträgern kraftschlüssig verbunden ist, wobei die Befestigungsmittel derartig angeordnet sind, dass eine Kraft senkrecht auf das Halbleiterelement wirkt, wobei die elastische Pufferlage in Richtung der Kraft komprimiert ist.

Überdies wird die Aufgabe erfindungsgemäß durch einen Stromrichter mit mindestens einer derartigen Halbleiteranordnung gelöst.

Darüber hinaus wird die Aufgabe erfindungsgemäß durch ein Verfahren zum Rezyklieren oder Reparieren einer derartigen Halbleiteranordnung umfassend folgende Schritte: Entfernen der Befestigungsmittel, Zerlegen der Halbleiteranordnung.

Die in Bezug auf das Herstellungsverfahren nachstehend angeführten Vorteile und bevorzugten Ausgestaltungen lassen sich sinngemäß auf die Halbleiteranordnung, den Stromrichter und das Verfahren zum Rezyklieren oder Reparieren übertragen.

Der Erfindung liegt die Überlegung zugrunde, die Rezyklierbarkeit oder Reparierbarkeit einer Halbleiteranordnung dadurch zu verbessern, dass üblicherweise verwendete stoffschlüssige und somit nicht oder nur schwer lösbare Verbindungen in einer Halbleiteranordnung, welche mittels planarer Aufbau- und Verbindungstechnik hergestellt wird, durch kraftschlüssige Verbindungen ersetzt werden. Die Halbleiteranordnung ist beispielsweise als Leistungshalbleiteranordnung für einen Stromrichter konfiguriert. Diese umfasst zumindest ein Halbleiterelement mit einem ersten Lastkontakt und einem auf einer dem ersten Lastkontakt gegenüberliegenden Seite zweiten Lastkontakt. Beispielsweise ist zumindest ein Halbleiterelement als vertikaler Leistungshalbleiter ausgeführt. Das zumindest ein Halbleiterelement wird durch Befestigungsmittel zwischen einem ersten Schaltungsträger und einem zweiten Schaltungsträger kraftschlüssig verbunden, wobei über die Befestigungsmittel eine senkrecht auf das Halbleiterelement wirkende Kraft übertragen wird. Auf diese Weise wird das zumindest eine Halbleiterelement, insbesondere zerstörungsfrei, lösbar zwischen den Schaltungsträgern verbunden. Der erste Schaltungsträger kann unter anderem als PCB (Printed Circuit Board) ausgeführt sein. Der zweite Schaltungsträger kann beispielsweise eine Metallplatte und/oder ein DCB-Substrat umfassen, wobei DCB dabei für "direct copper bonded" steht. Beispielsweise umfassen die Befestigungsmittel Schrauben, Bolzen und/oder Bügel, über welche die Schaltungsträger zusammengepresst werden. Zwischen dem ersten Schaltungsträger und dem ersten Lastkontakt des Halbleiterelements und/oder zwischen dem zweiten Schaltungsträger und dem zweiten Lastkontakt des Halbleiterelements wird eine elastische Pufferlage angeordnet, welche beim Zusammenpressen, insbesondere durch zumindest vorwiegend elastische Verformung, in Richtung der Kraft komprimiert wird. Die elastische Pufferlage kann elektrisch leitend oder elektrisch isolierend ausgeführt sein. Beispielsweise ist die elastische Pufferlage aus einem thermisch leitfähigen Werkstoff hergestellt, sodass ein Teil einer Verlustwärme, welche während eines Betriebes des Halbleiterelements entsteht, über die elastische Pufferlage abführbar ist. Unter anderem kann die elastische Pufferlage als ein Federblech, z.B. mit einer wellenförmigen Profilierung, ausgeführt sein. Alternativ können unter anderem, insbesondere metallische oder metallisierte, elastische Gitterstrukturen, welche z.B. durch 3D-Druck herstellbar sind, zum Einsatz kommen. Durch derartige Pufferlagen wird ein im Wesentlichen konstanter Anpressdruck und eine gleichmäßige elektrische Kontaktierung, insbesondere der Lastkontakte, auch über einen großen Temperaturbereich sichergestellt, wobei ferner ein einfaches Rezyklieren durch den Wegfall stoffschlüssiger Verbindungen ermöglicht wird.

Eine weitere Ausführungsform sieht vor, dass zumindest ein Halbleiterelement auf der Seite des ersten Lastkontakts einen Steuerkontakt aufweist, wobei der erste Lastkontakt und der Steuerkontakt elektrisch leitend mit dem ersten Schaltungsträger, welcher als Substrat ausgeführt ist, und der zweite Lastkontakt elektrisch leitend mit dem zweiten Schaltungsträger verbunden wird. Beispielsweise ist das Halbleiterelement als IGBT oder als vertikaler Wide-Bandgap-Transistor ausgeführt. Das Substrat kann unter anderem als PCB ausgeführt sein. Durch die Verbindung des ersten Lastkontakts und des Steuerkontakts mit dem Substrat kann der zweite Schaltungsträger einfacher ausgeführt sein.

Eine weitere Ausführungsform sieht vor, dass der erste Schaltungsträger eine erste Metallisierung aufweist, wobei die erste Metallisierung zumindest ein erstes Leitermuster, ein zweites Leitermuster und ein drittes Leitermuster umfasst, wobei der zweite Schaltungsträger zumindest eine erste Metalllage umfasst, wobei der erste Lastkontakt elektrisch leitend mit dem ersten Leitermuster der ersten Metallisierung verbunden wird, wobei der Steuerkontakt elektrisch leitend mit dem dritten Leitermuster der ersten Metallisierung verbunden wird und wobei der zweite Lastkontakt über die erste Metalllage und zumindest ein Verbindungselement elektrisch leitend mit dem zweiten Leitermuster der ersten Metallisierung verbunden wird. Durch die Verbindung des ersten Lastkontakts und des Steuerkontakts mit dem Substrat wird die Leitungsführung auf dem zweiten Schaltungsträger und zum ersten Schaltungsträger hin erheblich vereinfacht.

Eine weitere Ausführungsform sieht vor, dass die Befestigungsmittel das zumindest eine Verbindungselement umfassen. Insbesondere sind die Verbindungselemente, welche auch Umsteiger genannt werden, unter anderem hinsichtlich ihrer Stromtragfähigkeit so konfiguriert, dass sie während eines Betriebes der Halbleiteranordnung einen Laststrom führen können. Durch die gleichzeitige Verwendung der Befestigungsmittel zur mechanischen und elektrischen Verbindung wird die Schaltung vereinfacht und Bauraum eingespart.

Eine weitere Ausführungsform sieht vor, dass das zumindest eine Verbindungselement stoffschlüssig mit dem zweiten Leitermuster der ersten Metallisierung und der ersten Metalllage zur Herstellung der kraftschlüssigen Verbindung des Halbleiterelements mit den Schaltungsträgern verbunden wird. Die stoffschlüssige Verbindung ist beispielsweise durch Löten herstellbar. Insbesondere werden die Schaltungsträger zusammengepresst und somit die Pufferlage komprimiert, wobei die stoffschlüssige Verbindung im zusammengepressten Zustand hergestellt wird. Auf diese Weise wird eine einfache und zuverlässige Verbindung hergestellt.

Eine weitere Ausführungsform sieht vor, dass die erste Metalllage über eine dielektrische Materiallage mit einer Metallplatte verbunden ist, wobei die Metallplatte und der erste Schaltungsträger durch die Befestigungsmittel zur Herstellung der kraftschlüssigen Verbindung des Halbleiterelements mit den Schaltungsträgern, insbesondere lösbar, zusammengepresst werden. Über eine derartige Metallplatte sind lösbare Verbindungsmittel wie Schrauben einfach und zuverlässig verwendbar.

Eine weitere Ausführungsform sieht vor, dass die dielektrische Materiallage als elastische dielektrische Materiallage ausgeführt ist und als elastische Pufferlage fungiert. Die elastische dielektrische Materiallage ist beispielsweise aus einem Aluminiumoxid- oder Aluminiumnitrid gefüllten Silikon- oder Urethan-Elastomer hergestellt. Eine derartige elastische dielektrische Materiallage weist eine ausreichende thermische Leitfähigkeit auf, um zumindest einen Teil, insbesondere mehr als die Hälfte, einer Verlustwärme, welche während eines Betriebes des Halbleiterelements entsteht abzuführen. Ferner wird durch die elastische dielektrische Materiallage ein im Wesentlichen konstanter Anpressdruck und eine gleichmäßige thermische Kontaktierung sichergestellt, wobei ferner ein einfaches Rezyklieren durch den Wegfall stoffschlüssiger Verbindungen ermöglicht wird.

Eine weitere Ausführungsform sieht vor, dass die elastische Pufferlage eine elastische Metalllage umfasst. Die elastische Metalllage umfasst beispielsweise ein elektrisch leitfähiges Elastomerkomposit, welches mit Metallpartikeln, welche beispielsweise Kupfer und/oder Silber enthalten, oder Silber-Nanowires gefüllt ist. Ein derartiges leitfähiges Elastomerkomposit kann z.B. mittels Flach- oder Rollensiebdruck aufgetragen werden. Durch die mechanische Kompression eines derartigen mit Metallpartikeln oder Silber-Nanowires gefüllten Elastomerkomposits wird die elektrische Leitfähigkeit zusätzlich erhöht. Durch eine derartige elastische Metalllage wird gleichzeitig ein im Wesentlichen konstanter Anpressdruck auf das Halbleiterbauelement und eine elektrische Kontaktierung erreicht.

Eine weitere Ausführungsform sieht vor, dass elastische Metalllagen beidseitig zwischen dem Halbleiterelement und dem jeweiligen Schaltungsträger angeordnet werden. Durch eine beidseitige Anordnung ist das Halbleiterelement beidseitig kraftschlüssig und damit lösbar verbunden, sodass die Halbleiteranordnung beim Rezyklieren besonders leicht zerlegbar ist.

Eine weitere Ausführungsform sieht vor, dass zwischen den Schaltungsträgern eine schmelzbare Vergussmasse angeordnet wird, welche mit dem Halbleiterelement in unmittelbarem Kontakt steht. Die schmelzbare Vergussmasse kann z.B. einen Thermoplast enthalten. Beispielsweise kann die schmelzbare Vergussmasse einen elektrisch isolierenden Füllstoff, insbesondere Keramikpartikel, enthalten. Insbesondere kann die schmelzbare Vergussmasse zum Entfernen durch einen Erwärmungsvorgang zumindest teilweise verflüssigt oder verdampft werden, sodass die Vergussmasse einfach, insbesondere rückstandslos, entfernt werden kann. Ein einfaches Zerlegen zum Rezyklieren oder zur Reparatur wird durch eine derartige schmelzbare Vergussmasse ermöglicht.

Eine weitere Ausführungsform sieht vor, dass zwischen die Schaltungsträger ein elektrisch nicht-leitfähiges Wärmetransportfluid geleitet wird, welches mit dem Halbleiterelement in unmittelbarem Kontakt steht. Als Wärmetransportfluid kann unter anderem Perfluor-N-alkyl-morpholin zum Einsatz kommen, welches eine hohe Wärmeleitfähigkeit, einen geeigneten Siedepunkt und passende dielektrische Eigenschaften aufweist. Durch ein derartiges Wärmetransportfluid wird eine verbesserte Entwärmung während eines Betriebes der Halbleiterelements sowie ein einfaches Zerlegen zum Rezyklieren oder zur Reparatur ermöglicht.

Im Folgenden wird die Erfindung anhand der in den Figuren dargestellten Ausführungsbeispiele näher beschrieben und erläutert.

Es zeigen:
- FIG 1: eine schematische Schnittdarstellung einer ersten Ausführungsform einer Halbleiteranordnung,
- FIG 2: eine schematische Schnittdarstellung einer zweiten Ausführungsform einer Halbleiteranordnung,
- FIG 3: eine schematische Schnittdarstellung einer dritten Ausführungsform einer Halbleiteranordnung,
- FIG 4: eine schematische Schnittdarstellung einer vierten Ausführungsform einer Halbleiteranordnung,
- FIG 5: ein Rezyklieren der vierten Ausführungsform der Halbleiteranordnung in einer schematischen Schnittdarstellung,

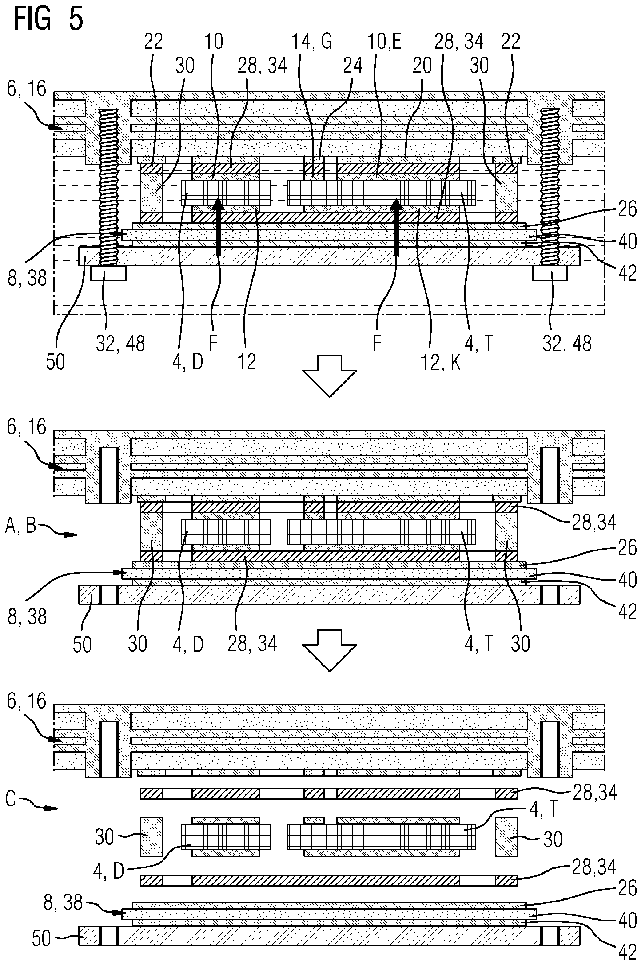

- FIG 5: eine schematische Schnittdarstellung einer fünften Ausführungsform einer Halbleiteranordnung,

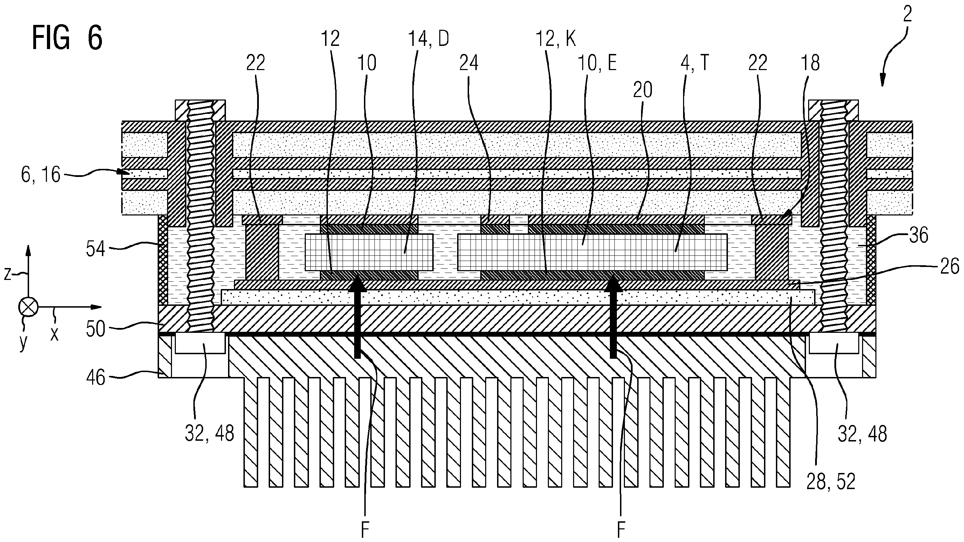

- FIG 6: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

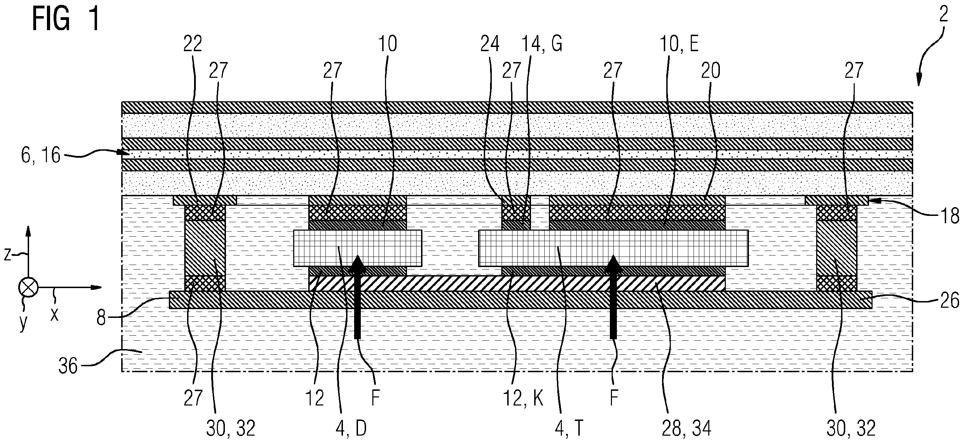

FIG 1 zeigt eine schematische Schnittdarstellung einer ersten Ausführungsform einer Halbleiteranordnung 2, welche Halbleiterelemente 4, einem ersten Schaltungsträger 6 und einem zweiten Schaltungsträger 8 umfasst. Beispielhaft sind die Halbleiterelemente 4 als ein Transistor T und als eine Diode D ausgeführt. Insbesondere ist die Diode D antiparallel zum Transistor T geschaltet. Alternativ kann die Halbleiteranordnung 2 zusätzliche Transistoren T und/oder Dioden D umfassen. Unter anderem kann mittels einer Mehrzahl von Transistoren T mit jeweils antiparallel geschalteten Dioden D eine Halbbrücke ausgebildet werden. Die als vertikale Leistungshalbleiterelemente ausgeführten Halbleiterelemente 4 weisen jeweils einen ersten Lastkontakt 10 und auf einer dem ersten Lastkontakt 10 gegenüberliegenden Seite einen zweiten Lastkontakt 12 auf. Ferner weist der Transistor T einen Steuerkontakt 14 auf. Der Transistor T ist beispielhaft als IGBT ausgeführt. Alternativ kann der Transistor T unter anderem als vertikaler SiC-MOSFET ausgeführt sein. Der erste Lastkontakt 10 des beispielhaft als IGBT ausgeführten Transistors T ist als Emitter E, der zweite Lastkontakt 12 als Kollektor K und der Steuerkontakt 14 als Gate G ausgeführt.

Der erste Schaltungsträger 6 ist als Substrat 16 mit einer ersten Metallisierung 18 ausgeführt, wobei die erste Metallisierung 18 ein erstes Leitermuster 20, ein zweites Leitermuster 22 und ein drittes Leitermuster 24 umfasst. Beispielsweise ist der erste Schaltungsträger 6 als Kunststoffleiterplatte, insbesondere als eine faserverstärkte Kunststoffleiterplatte, eine FR4-Leiterplatte oder als ein sogenanntes Hoch-Tg-PCB (aufweisend eine Glasübergangstemperatur T_{G} von größer als 150°C) aus Polyimid ausgestaltet. Der zweite Schaltungsträger 8 umfasst eine erste Metalllage 26, welche in FIG 1 als Metallplatte, die Kupfer enthält, ausgeführt ist. Die ersten Lastkontakte 10 der Halbleiterelemente 4 sind stoffschlüssig mit dem ersten Leitermuster 20 der ersten Metallisierung 18 verbunden ist, der Steuerkontakt 14 ist stoffschlüssig mit dem dritten Leitermuster 24 der ersten Metallisierung 18 verbunden. Die stoffschlüssige Verbindung 27 wird über Löten oder Sintern hergestellt.

Die zweiten Lastkontakte 12 der Halbleiterelemente 4 sind über eine elastische Pufferlage 28 elektrisch leitend auf dem zweiten Schaltungsträger 8 kontaktiert. Ferner sind die zweiten Lastkontakte 12 der Halbleiterelemente 4 unmittelbar lose, das heißt ohne eine stoffschlüssige Verbindung, über die elastische Pufferlage 28 mit dem zweiten Schaltungsträger 8 verbunden. Metallische Verbindungselemente 30, welche beispielsweise aus einem Lot- oder Sintermaterial gebildet sind, sind stoffschlüssig, mit dem zweiten Leitermuster 22 der ersten Metallisierung 18 des ersten Schaltungsträgers 6 und der ersten Metalllage 26 des zweiten Schaltungsträgers 8 verbunden. Die Verbindungselemente 30 können einen metallischen Kern, insbesondere einen Kupferkern, enthalten und/oder mehrteilig in Form von verschiedenen Schichten oder als Verbund ausgeführt sein. Die stoffschlüssige Verbindung wird beispielsweise durch Löten oder Sintern hergestellt. Die Verbindungselemente 30, welche auch Umsteiger genannt werden, sind unter anderem hinsichtlich ihrer Stromtragfähigkeit so konfiguriert, dass während eines Betriebes der Halbleiteranordnung 2 ein Laststrom über die metallischen Verbindungselemente 30 fließen kann. Ferner fungieren die Verbindungselemente 30 in FIG 1 zusätzlich als Befestigungsmittel 32, wobei die Halbleiterelemente 4 über die Befestigungsmittel 32 zwischen den Schaltungsträgern 6, 8 dadurch kraftschlüssig verbunden, dass über die Befestigungsmittel 32 eine senkrecht auf die Halbleiterelemente 4 wirkende Kraft F übertragen und die elastische Pufferlage 28 durch vorwiegend elastische Verformung in Richtung der Kraft F komprimiert wird. Die elastische Pufferlage 28 ist in FIG 1 als elastische Metalllage 34 ausgeführt. Die elastische Metalllage 34 kann unter anderem ein leitfähiges Elastomerkomposit, welches mit Metallpartikeln, welche beispielsweise Kupfer und/oder Silber enthalten, oder Silber-Nanowires gefüllt ist, sein. Ein derartiges leitfähiges Elastomerkomposit kann mittels Flach- oder Rollensiebdruck aufgetragen werden. Durch die mechanische Kompression eines derartigen mit Metallpartikeln oder Silber-Nanowires gefüllten Elastomerkomposits wird die elektrische Leitfähigkeit zusätzlich erhöht. Da der Steuerkontakt 14 des Halbleiterelements 4 mit dem Substrat 16 verbunden ist, kann die elastische Metalllage 34 als einfache unstrukturierte Lage ausgeführt sein.

Zur Herstellung der kraftschlüssigen Verbindung werden beispielsweise der erste Schaltungsträger 6 mit den stoffschlüssig verbundenen Halbleiterelementen 4, die elastische Pufferlage 28 und der zweite Schaltungsträger 8 derartig zusammengepresst, dass die elastische Pufferlage 28 durch vorwiegend elastische Verformung in Richtung der Kraft F komprimiert wird. In einem weiteren Schritt werden die Befestigungsmittel 32 im zusammengepressten Zustand zwischen den Schaltungsträgern 6, 8 stoffschlüssig verbunden, sodass die Halbleiterelemente 4 kraftschlüssig mit dem zweiten Schaltungsträger 8 verbunden sind. Während eines Betriebes der Halbleiteranordnung 2 wird ein elektrisch nicht-leitfähiges Wärmetransportfluid 36 unter anderem zwischen die Schaltungsträger 6, 8 geleitet, sodass das Wärmetransportfluid 36 in unmittelbarem Kontakt mit den Halbleiterelementen 4 steht. Unter anderem kann Perfluor-N-alkyl-morpholin als Wärmetransportfluid 36 zum Einsatz kommen, welches eine hohe Wärmeleitfähigkeit, einen geeigneten Siedepunkt und passende dielektrische Eigenschaften aufweist.

Zum Rezyklieren werden nach dem Entfernen des Wärmetransportfluids 36 die Schaltungsträger 6, 8 durch Entfernen der Befestigungsmittel 32 voneinander getrennt. Das Entfernen der Befestigungsmittel 32 erfolgt durch thermisches Lösen zumindest einer stoffschlüssigen Verbindungen 27 des jeweiligen Befestigungsmittels 32. Darauffolgend oder zeitgleich mit dem Entfernen der Befestigungsmittel 32 erfolgt ein Lösen der stoffschlüssigen Verbindung 27 der Halbleiterelemente 4, sodass in einem weiteren Schritt die Halbleiterelemente 4, die elastische Pufferlage 28 und die Schaltungsträger 6, 8 zerstörungsfrei getrennt und ggf. weiterverarbeitet werden.

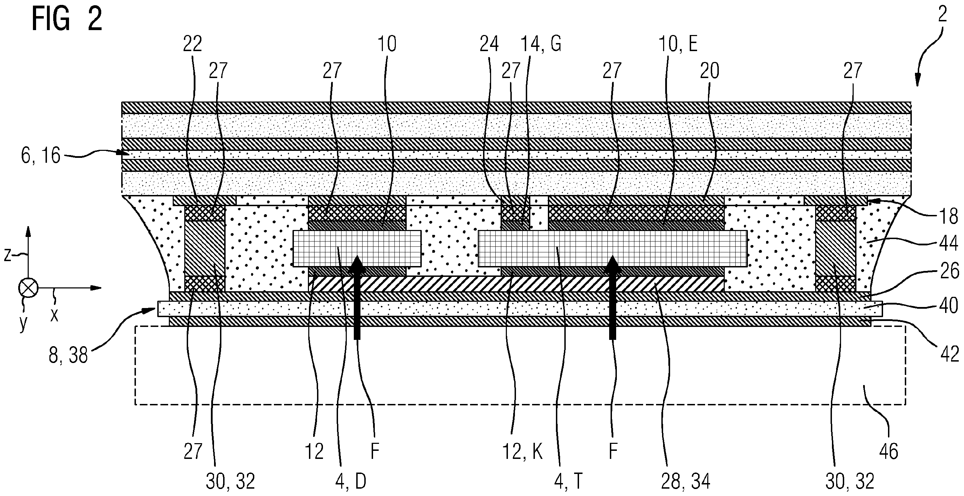

FIG 2 zeigt eine schematische Schnittdarstellung einer zweiten Ausführungsform einer Halbleiteranordnung 2, wobei der zweite Schaltungsträger 8 als keramisches Substrat 38 mit einer dielektrischen Materiallage 40, welche einen keramischen Werkstoff enthält, einer ersten Metalllage 26 und einer zweiten Metalllage 42 ausgebildet ist. Unter anderem kann das keramische Substrat 38 als DCB-Substrat ausgeführt sein. Zwischen den Schaltungsträgern 6, 8 wird eine schmelzbare Vergussmasse 44 angeordnet, welche mit den Halbleiterelementen 4 in unmittelbarem Kontakt steht. Die schmelzbare Vergussmasse 44 ist elektrisch isolierend ausgeführt und kann z.B. einen Thermoplast enthalten. Insbesondere kann ein elektrisch isolierender Füllstoff zum Einsatz kommen. Die zweiten Metalllage 42 des keramischen Substrats 38 kann mit einem, insbesondere metallischen, Kühlkörper 46 verbunden sein. Der Kühlkörper 46 kann die senkrecht auf die Halbleiterelement 4 wirkende Kraft F übertragen. Zum Rezyklieren wird zunächst die schmelzbare Vergussmasse 44, z.B. durch Erhitzen, im Wesentlichen rückstandslos entfernt. Die weitere Ausgestaltung der Halbleiteranordnung 2 in FIG 2 entspricht der Ausführung in FIG 1.

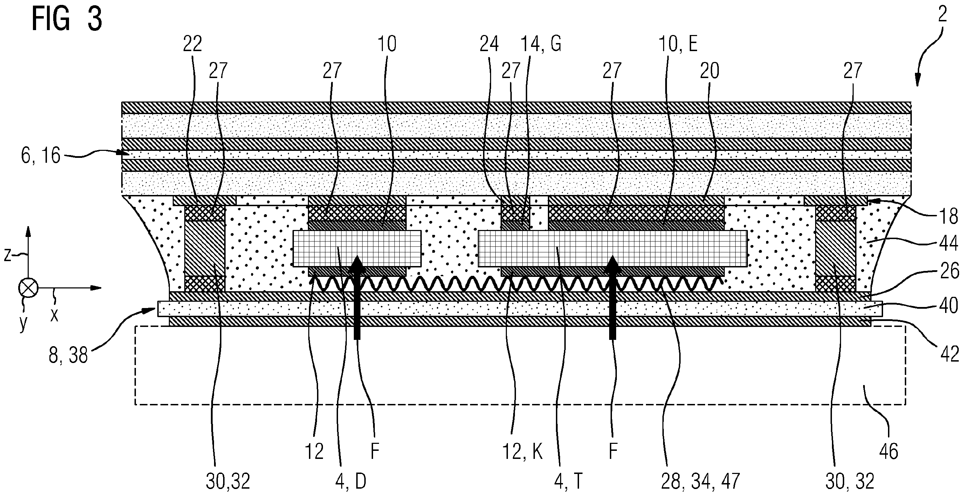

FIG 3 zeigt eine schematische Schnittdarstellung einer dritten Ausführungsform einer Halbleiteranordnung 2, wobei die elastische Metalllage 34 als profiliertes Kontaktierungselement 47 ausgeführt ist. Das profilierte Kontaktierungselement 47 weist beispielhaft eine wellenförmige Profilierung auf, welche vorwiegend elastisch verformbar ist. Beispielsweise enthält das profilierte Kontaktierungselement 47 eine elastische Kupferlegierung wie CuZn37, CuSn6, CuNi18Zn20, Kupfer-Beryllium oder einen Federstahl. Insbesondere ist das profilierte Kontaktierungselement 47 als Federblech ausgeführt. Alternativ kann die elastische Metalllage 34 unter anderem als metallische oder metallisierte elastische Gitterstruktur ausgeführt sein, welche z.B. durch 3D-Druck herstellbar ist. Die weitere Ausgestaltung der Halbleiteranordnung 2 in FIG 3 entspricht der Ausführung in FIG 2.

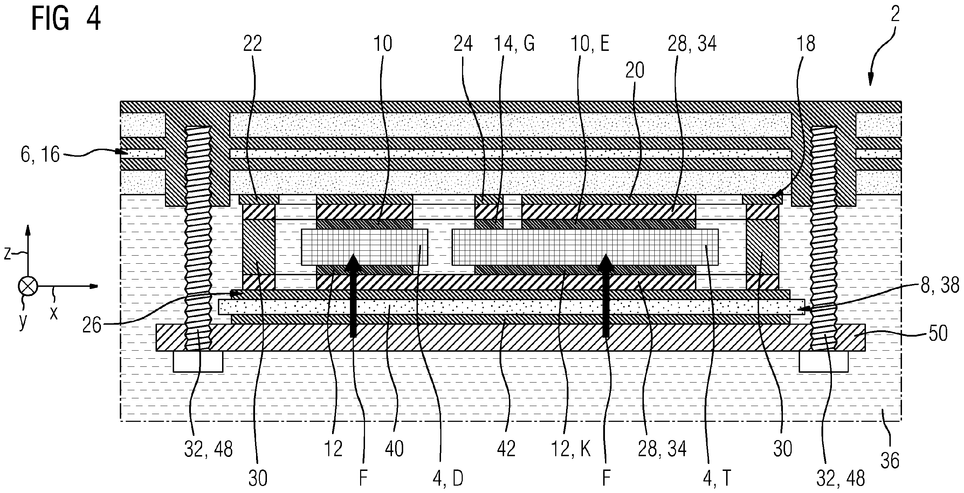

FIG 4 zeigt eine schematische Schnittdarstellung einer vierten Ausführungsform einer Halbleiteranordnung 2, wobei elastische Metalllagen 34 beidseitig zwischen den Halbleiterelementen 4 und dem jeweiligen Schaltungsträger 6, 8 angeordnet werden.

Für die ersten Lastkontakte 10 und zweiten Lastkontakte 12 der Halbleiterelemente 4 sowie für die Verbindungselemente 30 ist jeweils eine gemeinsame elastische Metalllage 34 vorgesehen. Die Verbindungselemente 30 werden zusammen mit den Halbleiterelementen 4 zwischen den elastischen Metalllagen 34 und den Schaltungsträgern 6 kraftschlüssig verbunden, wobei beispielsweise als Schrauben 48 ausgeführte Befestigungsmittel 32 die senkrecht auf die Halbleiterelemente 4 wirkende Kraft F übertragen. Zusätzlich oder alternativ können die Befestigungsmittel 32 Klemmen und/oder Federn zur Übertragung der Kraft F umfassen. Die erste Metalllage 26 des keramischen Substrats 16 ist über die dielektrischen Materiallage 40 elektrisch isolierend und thermisch leitend mit einer Metallplatte 50, welche unter anderem als Metallblech ausgeführt sein kann, verbunden über welche die Schrauben 48 mit dem ersten Schaltungsträger 6 verbunden werden. Über die Schrauben 48 werden die Metallplatte 50 und der erste Schaltungsträger 6 zur Herstellung der kraftschlüssigen Verbindung der Halbleiterelemente 4 mit den Schaltungsträgern 6, 8 lösbar zusammengepresst. Für eine präzise Kontaktierung können die elastischen Metalllagen 34 vor dem Zusammenpressen über eine, insbesondere temporäre oder leicht lösbare, adhäsive Verbindung mit dem ersten Schaltungsträger 6 bzw. dem zweiten Schaltungsträger 8 verbunden werden. Während eines Betriebes der Halbleiteranordnung 2 wird, wie in FIG 1 beschrieben, ein elektrisch nicht-leitfähiges Wärmetransportfluid 36 unter anderem zwischen die Schaltungsträger 6, 8 geleitet, sodass das Wärmetransportfluid 36 in unmittelbarem Kontakt mit den Halbleiterelementen 4 steht. Die weitere Ausgestaltung der Halbleiteranordnung 2 in FIG 4 entspricht der Ausführung in FIG 2.

FIG 5 zeigt ein Rezyklieren der vierten Ausführungsform der Halbleiteranordnung 2 in einer schematischen Schnittdarstellung. Das Rezyklieren umfasst nach einem Ablassen A des Wärmetransportfluids 36 ein Entfernen B der als Schraube 48 ausgeführten Befestigungsmittel 32.

In einem weiteren Schritt erfolgt ein Zerlegen C der Halbleiteranordnung 2 in einzelne Halbleiterelemente 4, elastische Pufferlagen 28 und Schaltungsträger 6, 8, beispielsweise zur weiteren Verarbeitung. Analog kann ein derartiges Zerlegen C zum Reparieren der Halbleiteranordnung 2, insbesondere zum Austausch von Komponenten, erfolgen.

FIG 6 zeigt eine schematische Schnittdarstellung einer fünften Ausführungsform einer Halbleiteranordnung 2, wobei der zweite Schaltungsträger 8 eine Metallplatte 50 umfasst, wobei die Metallplatte 50 und der erste Schaltungsträger 6 durch als Schrauben 48 ausgeführte Befestigungsmittel 32 zur Herstellung der kraftschlüssigen Verbindung der Halbleiterelemente 4 mit den Schaltungsträgern 6, 8 lösbar zusammengepresst werden. Die Halbleiterelemente 4 sind unmittelbar und lose auf der ersten Metallisierung 18 und auf der gegenüberliegenden Seite auf einer ersten Metalllage 26 kontaktiert, wobei die erste Metalllage 26 über eine elastische dielektrische Materiallage 52 unmittelbar mit der Metallplatte 50 verbunden ist. Die elastische dielektrische Materiallage 52 ist beispielsweise aus einem Aluminiumoxid- oder Aluminiumnitrid gefüllten Silikon- oder Urethan-Elastomer hergestellt und weist somit eine ausreichende thermische Leitfähigkeit auf, um zumindest einen Teil, insbesondere mehr als die Hälfte, einer Verlustwärme, welche während eines Betriebes des Halbleiterelements 4 entsteht, über die elastische dielektrische Materiallage 52 abzuführen. Die elastische dielektrische Materiallage 52 fungiert als elastische Pufferlage 28 und wird durch das Zusammenpressen der Schaltungsträger 6, 8 mittels der Schrauben 48 in Richtung der Kraft F komprimiert. Während eines Betriebes der Halbleiteranordnung 2 wird, wie in FIG 1 beschrieben, ein elektrisch nicht-leitfähiges Wärmetransportfluid 36 unter anderem zwischen die Schaltungsträger 6, 8 geleitet, sodass das Wärmetransportfluid 36 in unmittelbarem Kontakt mit den Halbleiterelementen 4 steht. Dichtungsmittel 54, welche beispielsweise stoffschlüssig, insbesondere adhäsiv mit dem ersten Schaltungsträger 6 und der Metallplatte 50 verbunden sind, verhindern ein Entweichen des Wärmetransportfluids 36. Die Dichtungsmittel 54 können ein Metallblech oder einen dielektrischen Werkstoff umfassen. Insbesondere wird die Halbleiteranordnung 2 im Bereich zwischen dem ersten Schaltungsträger 6 und der Metallplatte 50 durch die Dichtungsmittel 54 hermetisch abgedichtet. Die Metallplatte 50 ist, insbesondere stoffschlüssig, mit einem Kühlkörper 46 verbunden. Der Kühlkörper 46 und die Metallplatte 50 können alternativ einstückig ausgeführt sein, sodass die elastische dielektrische Materiallage 52 unmittelbar auf dem Kühlkörper 46 aufliegt und der Kühlkörper 46 und der erste Schaltungsträger 6 durch zur Herstellung der kraftschlüssigen Verbindung der Halbleiterelemente 4 mit den Schaltungsträgern 6, 8 lösbar zusammengepresst werden. Die weitere Ausgestaltung der Halbleiteranordnung 2 in FIG 6 entspricht der Ausführung in FIG 4.

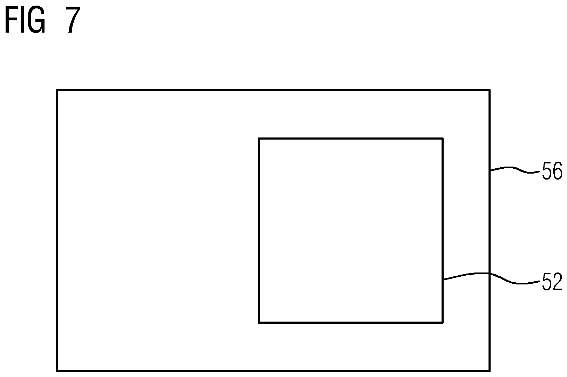

FIG 7 zeigt eine schematische Darstellung eines Stromrichters 56, welcher beispielhaft eine Halbleiteranordnung 2 umfasst.

Zusammenfassend betrifft die Erfindung ein Verfahren zur Herstellung einer Halbleiteranordnung 2, insbesondere einer Leistungshalbleiteranordnung für einen Stromrichter 56, mit zumindest einem Halbleiterelement 4, einem ersten Schaltungsträger 6 und einem zweiten Schaltungsträger 8. Um die Rezyklierbarkeit oder Reparierbarkeit einer Halbleiteranordnung, welche mittels planarer Aufbau- und Verbindungstechnik realisiert ist, zu verbessern, wird vorgeschlagen, dass das Halbleiterelement 4 einen ersten Lastkontakt 10 und auf einer dem ersten Lastkontakt 10 gegenüberliegenden Seite einen zweiten Lastkontakt 12 aufweist, wobei zwischen dem ersten Schaltungsträger 6 und dem ersten Lastkontakt 10 des Halbleiterelements 4 und/oder zwischen dem zweiten Schaltungsträger 8 und dem zweiten Lastkontakt 12 des Halbleiterelements 4 eine elastische Pufferlage 28 angeordnet wird, wobei das Halbleiterelement 4 durch Befestigungsmittel 32 zwischen den Schaltungsträgern 6, 8 kraftschlüssig verbunden wird, wobei über die Befestigungsmittel 32 eine senkrecht auf das Halbleiterelement 4 wirkende Kraft F übertragen wird, wobei die elastische Pufferlage 28 in Richtung der Kraft F komprimiert wird.

## Patentansprüche

1. Verfahren zur Herstellung einer Halbleiteranordnung (2), insbesondere einer Leistungshalbleiteranordnung für einen Stromrichter (56), mit zumindest einem Halbleiterelement (4), einem ersten Schaltungsträger (6) und einem zweiten Schaltungsträger (8),
wobei das Halbleiterelement (4) einen ersten Lastkontakt (10) und auf einer dem ersten Lastkontakt (10) gegenüberliegenden Seite einen zweiten Lastkontakt (12) aufweist,
wobei zwischen dem ersten Schaltungsträger (6) und dem ersten Lastkontakt (10) des Halbleiterelements (4) und/oder
zwischen dem zweiten Schaltungsträger (8) und dem zweiten Lastkontakt (12) des Halbleiterelements (4) eine elastische Pufferlage (28) angeordnet wird,
wobei das Halbleiterelement (4) durch Befestigungsmittel (32) zwischen den Schaltungsträgern (6, 8) kraftschlüssig verbunden wird,
wobei über die Befestigungsmittel (32) eine senkrecht auf das Halbleiterelement (4) wirkende Kraft (F) übertragen wird,
wobei die elastische Pufferlage (28) in Richtung der Kraft (F) komprimiert wird.

2. Verfahren nach Anspruch 1,
wobei zumindest ein Halbleiterelement (4) auf der Seite des ersten Lastkontakts (10) einen Steuerkontakt (14) aufweist,
wobei der erste Lastkontakt (10) und der Steuerkontakt (14) elektrisch leitend mit dem ersten Schaltungsträger (6), welcher als Substrat (16) ausgeführt ist, und der zweite Lastkontakt (12) elektrisch leitend mit dem zweiten Schaltungsträger (8) verbunden wird.

3. Verfahren nach Anspruch 2,
wobei der erste Schaltungsträger (6) eine erste Metallisierung (18) aufweist,
wobei die erste Metallisierung (18) zumindest ein erstes Leitermuster (20), ein zweites Leitermuster (22) und ein drittes Leitermuster (24) umfasst,
wobei der zweite Schaltungsträger (8) zumindest eine erste Metalllage (26) umfasst,
wobei der erste Lastkontakt (10) elektrisch leitend mit dem ersten Leitermuster (20) der ersten Metallisierung (18) verbunden wird,
wobei der Steuerkontakt (14) elektrisch leitend mit dem dritten Leitermuster (24) der ersten Metallisierung (18) verbunden wird und
wobei der zweite Lastkontakt (12) über die erste Metalllage (26) und zumindest ein Verbindungselement (30) elektrisch leitend mit dem zweiten Leitermuster (22) der ersten Metallisierung (18) verbunden wird.

4. Verfahren nach Anspruch 3,
wobei die Befestigungsmittel (32) das zumindest eine Verbindungselement (30) umfassen.

5. Verfahren nach Anspruch 4,
wobei das zumindest eine Verbindungselement (30) stoffschlüssig mit dem zweiten Leitermuster (22) der ersten Metallisierung (18) und der ersten Metalllage (26) zur Herstellung der kraftschlüssigen Verbindung des Halbleiterelements (4) mit den Schaltungsträgern (6, 8) verbunden wird.

6. Verfahren nach einem der Ansprüche 1 bis 3,
wobei die erste Metalllage (26) über eine dielektrische Materiallage (40) mit einer Metallplatte (50) verbunden ist,
wobei die Metallplatte (50) und der erste Schaltungsträger (6) durch die Befestigungsmittel (32) zur Herstellung der kraftschlüssigen Verbindung des Halbleiterelements (4) mit den Schaltungsträgern (6, 8), insbesondere lösbar, zusammengepresst werden.

7. Verfahren nach Anspruch 6,
wobei die dielektrische Materiallage (40) als elastische dielektrische Materiallage (52) ausgeführt ist und als elastische Pufferlage (28) fungiert.

8. Verfahren nach einem der vorherigen Ansprüche,
wobei die elastische Pufferlage (28) eine elastische Metalllage (34) umfasst.

9. Verfahren nach Anspruch 8,
wobei elastische Metalllagen (34) beidseitig zwischen dem Halbleiterelement (4) und dem jeweiligen Schaltungsträger (6, 8) angeordnet werden.

10. Verfahren nach einem der Ansprüche 1 bis 9,
wobei zwischen den Schaltungsträgern (6, 8) eine schmelzbare Vergussmasse (44) angeordnet wird, welche mit dem Halbleiterelement (4) in unmittelbarem Kontakt steht.

11. Verfahren nach einem der Ansprüche 1 bis 9,
wobei zwischen die Schaltungsträger (6, 8) ein elektrisch nicht-leitfähiges Wärmetransportfluid (36) geleitet wird, welches mit dem Halbleiterelement (4) in unmittelbarem Kontakt steht.

12. Halbleiteranordnung (2), insbesondere Leistungshalbleiteranordnung für einen Stromrichter (56), mit zumindest einem Halbleiterelement (4), einem ersten Schaltungsträger (6) und einem zweiten Schaltungsträger (8),
wobei das Halbleiterelement (4) einen ersten Lastkontakt (10) und auf einer dem ersten Lastkontakt (10) gegenüberliegenden Seite einen zweiten Lastkontakt (12) aufweist,
wobei zwischen dem ersten Schaltungsträger (6) und dem ersten Lastkontakt (10) des Halbleiterelements (4) und/oder
zwischen dem zweiten Schaltungsträger (8) und dem zweiten Lastkontakt (12) des Halbleiterelements (4) eine elastische Pufferlage (28) angeordnet ist,
wobei das Halbleiterelement (4) durch Befestigungsmittel (32) zwischen den Schaltungsträgern (6, 8) kraftschlüssig verbunden ist,
wobei die Befestigungsmittel (32) derartig angeordnet sind, dass eine Kraft (F) senkrecht auf das Halbleiterelement (4) wirkt,
wobei die elastische Pufferlage (28) in Richtung der Kraft (F) komprimiert ist.

13. Halbleiteranordnung (2) nach Anspruch 12,
wobei die elastische Pufferlage (28) eine elastische Metalllage (34) und/oder eine elastische dielektrische Materiallage (52) umfasst.

14. Stromrichter (56) mit mindestens einer Halbleiteranordnung (2) nach einem der Ansprüche 12 oder 13.

15. Verfahren zum Rezyklieren oder Reparieren einer Halbleiteranordnung (2) nach einem der Ansprüche 12 oder 13 umfassend folgende Schritte:
- Entfernen (B) der Befestigungsmittel (32)
- Zerlegen (C) der Halbleiteranordnung (2).
